# EUROPEAN PATENT SPECIFICATION

(11) **EP 2 988 581 B1**
(45) Date of publication and mention of the grant of the patent: **13.05.2020**
(21) Application number: 14878386.3
(22) Date of filing: 23.06.2014
(51) Int. Cl.: H05K 7/20

(54) **CHIP HEAT DISSIPATION STRUCTURE AND TERMINAL DEVICE**
CHIP-WÄRMEABLEITUNGSSTRUKTUR UND ENDGERÄT
STRUCTURE DE DISSIPATION DE CHALEUR DE PUCE ET DISPOSITIF TERMINAL

(43) Date of publication of application: 24.02.2016
(73) Proprietor: Huawei Technologies Co., Ltd., Longgang District Shenzhen, Guangdong 518129 (CN)
(72) Inventor: GUO, Junsheng, Shenzhen Guangdong 518129 (CN); KUANG, Mingqiang, Shenzhen Guangdong 518129 (CN); SUN, Lue, Shenzhen Guangdong 518129 (CN)
(74) Representative: Thun, Clemens
(86) International application number: PCT/CN2014/080532
(87) International publication number: WO 2015/196340

(56) References cited:
- CN-A- 1 206 326
- CN-A- 1 564 331
- CN-A- 101 872 830
- CN-A- 102 176 498
- CN-A- 102 297 346
- JP-A- 2008 180 633

## Description

### TECHNICAL FIELD

The present invention relates to a chip heat dissipation structure and a terminal device that has the chip heat dissipation structure.

### BACKGROUND

With rapid development of communications technologies, the mobile Internet has been widely applied, for example, a wireless communications technology is applied to a vehicle-mounted positioning terminal system and a vehicle-mounted video to implement functions thereof, and a SIM card needs to be carried so as to implement a function, such as signal transmission. A SIM card used in an existing vehicle-mounted terminal is fixed on a circuit board through a card holder. Because a high temperature is easily caused in a specific environment of vehicle-mounting and a CPU and the like of a circuit board dissipate heat, the SIM card is easily distorted or damaged.

JP 2008180633 discloses a substrate for a sensor element which comprises a surface layer where a GMR element group having a temperature characteristic is mounted and exothermic ASICs are mounted near the GMR element group. An inner layer that is overlaid on the surface layer and has a copper foil pattern for releasing heat generated by driving of the GMR element group and the ASICs. A slit for reducing the thermal conductivity comparing with other parts is disposed between the position corresponding to the GMR element group in the copper foil pattern and the position corresponding to the ASICs.

### SUMMARY

Embodiments of the present invention provide a terminal device with a chip heat dissipation structure, so as to reduce heat endured by a chip.

According to the present invention, a terminal device is provided with a chip heat dissipation structure, wherein the chip heat dissipation structure is disposed on a printed circuit board, PCB, of the terminal device wherein the chip heat dissipation structure comprises a chip card holder and at least one isolation groove; the chip card holder and the PCB are molded into one body; and the at least one isolation groove is disposed on the PCB and located around the chip card holder, and the at least one isolation groove is configured to isolate an area in which the chip card holder is located from another area on the PCB;
wherein the area in which the chip card holder is located is connected to the another area on the PCB through a connecting area;
wherein the isolation groove is separated into at least two through grooves, wherein the at least two through grooves are disposed around the chip card holder; and wherein the chip card holder is electrically connected to the PCB by means of wiring, the wiring being arranged in the connecting area.

In a conclusion, a chip card holder of a chip heat dissipation structure in the present invention is isolated from another part on a circuit board through at least one isolation groove, which reduces heat, which is transferred to the chip card holder through the circuit board, at another position on the circuit board, thereby reducing heat of the chip card holder and preventing a chip in the chip card holder from being distorted or damaged.

### BRIEF DESCRIPTION OF DRAWINGS

To describe the technical solutions in the embodiments of the present invention more clearly, the following briefly introduces the accompanying drawings required for describing the embodiments. Apparently, the accompanying drawings in the following description show merely some embodiments of the present invention, and a person of ordinary skill in the art may still derive other drawings from these accompanying drawings without creative efforts.
FIG. 1 is a schematic plan diagram of a chip heat dissipation structure according to an embodiment of the present invention;
FIG. 2 is a schematic plan diagram of a chip heat dissipation structure according to another embodiment of the present invention;
FIG. 3 is a structural block diagram of a terminal device according to an embodiment of the present invention; and
FIG. 4 is a structural block diagram of a terminal device according to another embodiment of the present invention.

### DESCRIPTION OF EMBODIMENTS

The present invention provides a chip heat dissipation structure, which can reduce heat that is endured by a chip in an external environment, thereby preventing the chip from being distorted due to an overhigh temperature.

To make a person skilled in the art understand the technical solutions in the present invention better, the following clearly and completely describes the technical solutions in the embodiments of the present invention with reference to the accompanying drawings in the embodiments of the present invention. Apparently, the described embodiments are merely a part rather than all of the embodiments of the present invention. All other embodiments obtained by a person of ordinary skill in the art based on the embodiments of the present invention without creative efforts shall fall within the protection scope of the present invention.

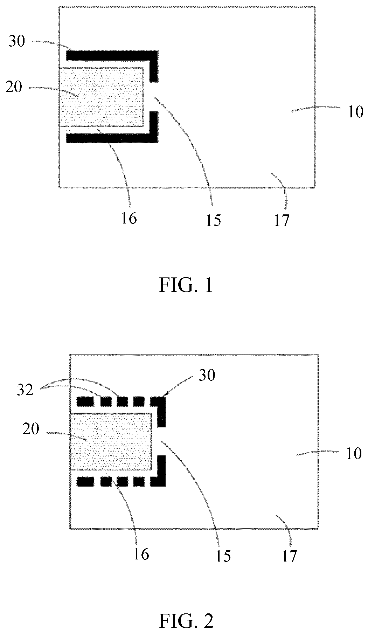

FIG. 1 is a schematic plan diagram of a chip heat dissipation structure according to an embodiment of the present invention. As shown in FIG. 1, the chip heat dissipation structure provided in this embodiment of the present invention is disposed on a printed circuit board 10 (Printed Circuit Board, PCB) of a terminal device. The chip heat dissipation structure includes a chip card holder 20 and at least one isolation groove 30, and the chip card holder 20 and the PCB 10 are molded into one body. The at least one isolation groove 30 is disposed on the PCB 10 and located around the chip card holder 20, and so that an area in which the chip card holder 20 is located is isolated from another area of the PCB 10, thereby implementing isolation of heat dissipation of a chip inside the chip card holder 20.

In this embodiment, the chip heat dissipation structure may be applied to a mobile terminal, such as a vehicle-mounted terminal, a mobile phone, or a tablet computer. The chip may be a SIM card or may be a storage card. The chip card holder 20 is configured to carry the chip, and an electrical connection terminal that connects to the chip inside the chip card holder 20 is directly disposed on the printed circuit board 10. Specifically, for the SIM card, when the SIM card is disposed in a terminal device such as a vehicle-mounted device, because a high temperature is easily caused in an internal environment of the terminal and a CPU and the like of the circuit board dissipate heat, the SIM card is easily distorted or damaged; therefore, at least one isolation groove 30 is disposed around the chip card holder 20 so as to isolate the chip card holder 20 from another part of the PCB 10, which avoids that heat that is generated by a component such as the CPU on the circuit board is transferred to the chip card holder 20 through the circuit board, and reduces heat of the chip card holder 20, thereby preventing the chip inside the chip card holder 20 from being distorted or damaged.

Further, a connecting area 15 is disposed between an area in which the PCB 10 carries the chip card holder 20 and another area of the PCB 10, and is configured to arrange wiring of the chip card holder 20 and wring of the PCB 10. Specifically, the area in which the chip card holder 20 is carried is a carrying area 16. The another area of the PCB 10 is a mainboard area 17. The connecting area 15 connects the carrying area 16 and the mainboard area 17, so that the connecting area 15 connects the chip card holder 20 and a layout of a signal line of the PCB 10.

Further, the isolation groove 30 is a bar structure. The isolation groove 30 separates the carrying area 16 and the mainboard area 17, so as to reduce heat that is generated by a component on the printed circuit board 10 and transferred to the carrying area 16.

Referring to FIG. 2, in another embodiment of the present invention, the isolation groove 30 is separated into at least two through grooves 32, where the at least two through grooves 32 are disposed around the chip card holder 20, and specifically, the at least two through grooves 32 penetrate the PCB 10. In this embodiment, there are multiple through grooves 32 and the through grooves 32 are disposed at an interval. The multiple through grooves 32 are arranged from one side of the connecting area to form a breakpoint strip around the chip card holder 20, and the number of the through grooves 32 is set according to a design requirement of the chip card holder 20. The breakpoint strip formed by the multiple through grooves 32 disposed at an interval isolates the chip card holder 20, which meets a connecting requirement of a medium layer of the circuit board. The signal line on the PCB 10 may pass through a part between every two through grooves 32, which can ensure signal quality and can further ensure a requirement for anti-vibration and deformation of the circuit board.

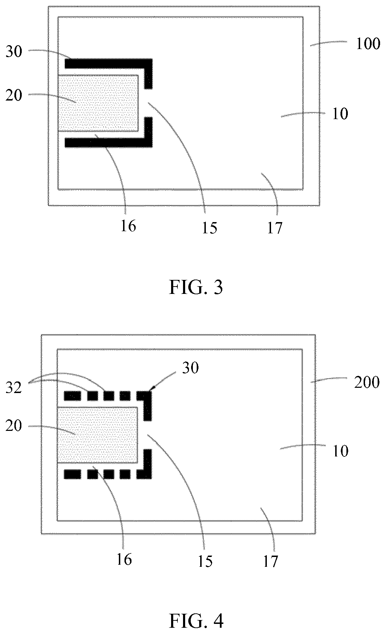

Referring to FIG. 3, the present invention further provides a terminal device 100, where the terminal device 100 includes the printed circuit board (PCB) 10 and the chip heat dissipation structure provided in the embodiment of the present invention and shown in FIG. 1. The chip heat dissipation structure is configured to carry a chip and perform heat dissipation for the chip, the chip card holder 20 is connected to the PCB 10 electrically by means of wiring, and the wiring is arranged in the connecting area 15.

In another embodiment of the present invention, other electronic components, such as a central processing unit (not shown in the figure) and a power processor (not shown in the figure) are further disposed on the PCB 10. The power processor implements an electrical connection between the chip inside the chip card holder 20 and the central processing unit, and the central processing unit implements running of the terminal device 100. Because an isolation groove is disposed on an edge of the chip card holder 20, heat generated by an electronic component on the PCB 10, such as the central processing unit, is isolated by the isolation groove, which reduces heat, which is transferred to the chip card holder 20 through the circuit board, of a component, such as the CPU, on the circuit board, and reduces a probability of damage to the chip inside the chip card holder 20 and damage to an electrical connection terminal that connects to the chip, thereby improving stability of the terminal device 100. Referring to FIG. 4, the present invention further provides a terminal device 200, where the terminal device 200 includes the printed circuit board (PCB) 10 and the chip heat dissipation structure provided in the another embodiment of the present invention and shown in FIG. 2. The chip heat dissipation structure is configured to carry a chip and perform heat dissipation for the chip, the chip card holder 20 is connected to the PCB 10 electrically by means of wiring, and the wiring is arranged in the connecting area 15. The breakpoint strip, which is formed by the multiple through grooves 32 disposed at an interval, of the chip heat dissipation structure isolates the chip card holder 20, which meets a connecting requirement of a medium layer of the circuit board. The signal line on the PCB 10 may pass through a part between every two through grooves 32, which can ensure signal quality and can further ensure stability of the terminal device 200.

## Claims

1. A terminal device with a chip heat dissipation structure, wherein the chip heat dissipation structure is disposed on a printed circuit board, PCB, (10) of the terminal device wherein the chip heat dissipation structure comprises a chip card holder (20) and at least one isolation groove (30); the chip card holder (20) and the PCB (10) are molded into one body; and the at least one isolation groove (30) is disposed on the PCB (10) and located around the chip card holder (20), and the at least one isolation groove (30) is configured to isolate an area in which the chip card holder (20) is located from another area on the PCB (10);
wherein the area in which the chip card holder (20) is located is connected to the another area on the PCB (10) through a connecting area (15);
wherein the isolation groove (30) is separated into at least two through grooves, wherein the at least two through grooves are disposed around the chip card holder (20); and
wherein the chip card holder (20) is electrically connected to the PCB (10) by means of wiring, the wiring being arranged in the connecting area (15).

2. The terminal device according to claim 1, wherein the at least one isolation groove (30) is a bar structure, and the isolation groove (30) is disposed from one side of the connecting area (15) and along an edge of the chip card holder (20).

## Patentansprüche

1. Endgerät mit einer Chip-Wärmeableitungsstruktur, wobei die Chip-Wärmeableitungsstruktur auf einer Leiterplatte, PCB, (10) des Endgeräts angeordnet ist, wobei die Chip-Wärmeableitungsstruktur einen Chipkartenhalter (20) und mindestens eine Isolationsrille (30) aufweist; der Chipkartenhalter (20) und die PCB (10) in einen Hauptteil eingegossen sind; und die mindestens eine Isolationsrille (30) auf der PCB (10) angeordnet ist und sich um den Chipkartenhalter (20) herum befindet, und die mindestens eine Isolationsrille (30) ausgelegt ist zum Isolieren eines Gebiets, in welchem sich der Chipkartenhalter (20) befindet, von einem anderen Gebiet auf der PCB (10);
wobei das Gebiet, in welchem sich der Chipkartenhalter (20) befindet, mit dem anderen Gebiet auf der PCB (10) über ein Verbindungsgebiet (15) verbunden ist;
wobei die Isolationsrille (30) in mindestens zwei Durchrillen getrennt ist, wobei die mindestens zwei Durchrillen um den Chipkartenhalter (20) herum angeordnet sind; und
wobei der Chipkartenhalter (20) mittels Verdrahtung mit der PCB (10) elektrisch verbunden ist, wobei die Verdrahtung in dem Verbindungsgebiet (15) eingerichtet ist.

2. Endgerät nach Anspruch 1, wobei die mindestens eine Isolationsrille (30) eine Sperrstruktur ist und die Isolationsrille (30) von einer Seite des Verbindungsgebiets (15) und entlang einer Kante des Chipkartenhalters (20) angeordnet ist.

## Revendications

1. Dispositif terminal ayant une structure de dissipation de chaleur de puce, dans lequel la structure de dissipation de chaleur de puce est disposée sur une carte de circuit imprimé (PCB) (10) du dispositif terminal, dans lequel la structure de dissipation de chaleur de puce comprend un support de carte à puce (20) et au moins une rainure d'isolation (30) ; le support de carte à puce (20) et la carte de circuit imprimé (10) sont moulés dans un corps ; et la ou les rainures d'isolation (30) sont disposées sur la carte de circuit imprimé (10) et situées autour du support de carte à puce (20) et la ou les rainures d'isolation (30) sont configurées pour isoler une zone dans laquelle le support de carte à puce (20) est situé, d'une autre zone sur la carte de circuit imprimé (10) ;
dans lequel la zone dans laquelle le support de carte à puce (20) est situé, est reliée à l'autre zone sur la carte de circuit imprimé (10) par le biais d'une zone de connexion (15) ;
dans lequel la rainure d'isolation (30) est séparée en au moins deux rainures traversantes, dans lequel les deux, ou plus, rainures traversantes sont disposées autour du support de carte à puce (20) ; et
dans lequel le support de carte à puce (20) est raccordé électriquement à la carte de circuit imprimé (10) au moyen d'un câblage, le câblage étant agencé dans la zone de connexion (15).

2. Dispositif terminal selon la revendication 1, dans lequel la ou les rainures d'isolation (30) constituent une structure de barre et la rainure d'isolation (30) est disposée à partir d'un côté de la zone de connexion (15) et le long d'un bord du support de carte à puce (20).
